# EUROPÄISCHE PATENTANMELDUNG

(11) **EP 0 642 084 A1**
(43) Veröffentlichungstag der Anmeldung: **08.03.1995**
(21) Anmeldenummer: 94111495.1
(22) Anmeldetag: 22.07.1994
(51) Int. Cl.: G06F 11/26

(54) **Integrierte Logikschaltung mit Testmöglichkeit**

(30) Priorität: 04.08.1993 DE 4326214
(71) Anmelder: SIEMENS AKTIENGESELLSCHAFT, D-80333 München (DE)
(72) Erfinder: Klebsch, Wolfgang, Dr., Dipl.-Phys., D-82377 Penzberg (DE); Bode, Hans-Jörgen, Dipl.-Ing., D-81669 München (DE); Hechler, Egbert, Dr. Dipl.-Ing., D-85586 Poing (DE)

(57) **Zusammenfassung**

Integrierte Logikschaltung mit mehreren miteinander gekoppelten, jeweils deaktivierbaren Schaltungsblöcken (SB1 bis SB5), die für sich jeweils durch Vergleich von an den Blockeingängen angelegten Eingangsbitmustern (ebm) mit daraus resultierenden Ausgangsbitmustern (abm) an den Blockausgängen testbar sind, und mit einer Testmodussteuerung (TMS), die zum Testen eines durch ein Selektionssignal (sel) ausgewählten, einzelnen Schaltungsblocks dessen Blockeingänge und Blockausgänge mittels einer Schalteinrichtung (SE) auf Anschlußpins, an die die Eingangsbitmuster (ebm) angelegt werden und die die Ausgangsbitmuster (abm) abgeben, aufschaltet und die übrigen Schaltungsblöcke deaktiviert.

## Beschreibung

Die Erfindung betrifft eine integrierte Logikschaltung.

Mit jedem neuen Technologieschritt nimmt die Packungsdichte der Transistoren und sonstigen Bauelemente bei integrierten Schaltungen und damit der potentielle Integrationsgrad stetig zu. Der Aufwand für die Entwicklung von Testprogrammen und die Erstellung von Prüfverfahren erreicht bereits heute Ausmaße, die mit dem eigentlichen Entwicklungsaufwand vergleichbar sind. Außerdem führt die fortschreitende Zunahme der Funktionalität zu einer logischen Tiefe, die das Ziel einer vollständigen Fehleraufdeckung in immer weitere Ferne rückt.

Die Aufgabe der Erfindung besteht darin, eine integrierte Logikschaltung anzugeben, die mit geringem Aufwand effizient testbar ist.

Die Aufgabe wird gelöst durch eine integrierte Logikschaltung mit mehreren miteinander gekoppelten, jeweils deaktivierbaren Schaltungsblöcken, die für sich jeweils durch Vergleich von an den Blockeingängen angelegten Eingangsbitmustern mit daraus resultierenden Ausgangsbitmustern an den Blockausgängen testbar sind, und mit einer Auswahlsteuerung, die zum Testen eines durch ein Selektionssignal ausgewählten, einzelnen Schaltungsblocks dessen Blockeingänge und Blockausgänge mittels einer Schalteinrichtung auf Anschlußpins, an die die Eingangsbitmuster angelegt und die Ausgangsbitmuster abgenommen werden, aufschaltet und die übrigen Schaltungsblöcke deaktiviert.

Eine Weiterbildung der Erfindung sieht vor, daß zwischen die Schaltungsblöcke durch die Auswahlsteuerung gesteuerte Schnittstellen für einen Test nach dem Boundary-Scan-Verfahren geschaltet sind.

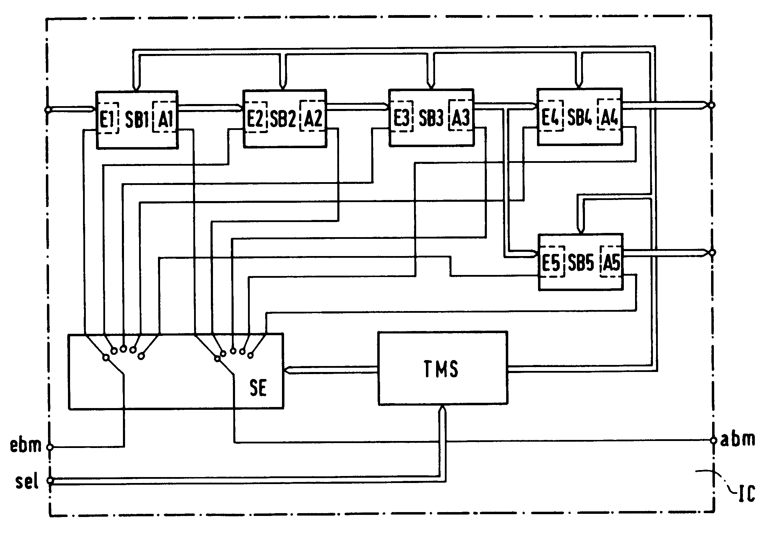

Die Erfindung wird nachfolgend anhand des in der einzigen Figur der Zeichnung dargestellten Ausführungsbeispiels näher erläutert.

Eine gegebene integrierte Logikschaltung IC besteht aus fünf Schaltungsblöcken SB1 bis SB5, von denen vier, nämlich die Schaltungsblöcke SB1 bis SB4 hintereinander geschaltet sind und der Schaltungsblock SB5 ebenso wie der Schaltungsblock SB4 dem Schaltungsblock SB3 nachgeschaltet ist. Jeder der Schaltungsblöcke SB1 bis SB5 bildet eine eigene, abgeschlossene funktionelle Einheit, die für sich einzeln testbar ist. Zum Testen werden an die jeweiligen Blockeingänge bestimmte Bitmuster angelegt und die daraus resultierenden Ausgangsbitmuster an den Blockausgängen damit verglichen. Zum Testen eines durch ein Selektionssignal sel ausgewählten, einzelnen Schaltungsblocks werden dessen Blockeingange und Blockausgänge mittels einer Schalteinrichtung SE auf Anschlußpins der integrierten Logikschaltung IC aufgeschaltet. Bei den Anschlußpins kann es sich dabei um bereits vorhandene, also im üblichen Betriebsfalls bereits verwendete Anschlußpins oder aber um zusätzlicher Anschlußpins handeln. An den entsprechenden Anschlußpins werden demzufolge bestimmte Eingangsbitmuster ebm angelegt, die über die Schalteinrichtung SE an den jeweils ausgewählten Schaltungsblock gelangt. Dementsprechend werden die am Ausgang dieses Schaltungsblocks anliegenden Ausgangsbitmuster über die Schalteinrichtung SE an die zugehörigen Anschlußbits übertragen und können dort abgenommen werden. Darüber hinaus wird durch die Testmodussteuerung TMS die Deaktivierung sämtlicher, nicht ausgewählter Schaltungsblöcke eingeleitet.

Die Erfindung weiterbildend weisen die Schaltungsblöcke SB1 bis SB5 an ihren Eingängen und Ausgängen durch die Testmodussteuerung TMS gesteuerte Schnittstellen E1 bis E5 bzw. A1 bis A5 für einen Test nach dem Boundary-Scan-Verfahren auf. Eine Boundary-Scan-Architektur sowie ein Standard-Test-Access-Port wurden von der Joint-Test-Action-Group (JTAG) definiert (vgl. IEEE Standard 1149.1/D6, Standard-Test-Access-Port and Boundary-Scan-Architecture, Draft, Nov. 22, 1989). Bei einer diesem Standard entsprechenden Schaltung werden zum Testen Befehle und zugehörige Daten in eine Schaltungskomponente seriell eingelesen und nach Ausführung des Befehls das Ergebnis seriell ausgelesen. Die Abfolge der einzelnen Operationen wird durch eine spezielle Steuerung bestimmt und überwacht. Als Steuerung fungiert entweder eine automatische Testeinrichtung oder eine Schaltungskomponente, die mit einem, zu einer umfassenden Wartungseinrichtung gehörenden Testbus gekoppelt ist. Zur Überwachung und Ablaufsteuerung werden Testmodusauswahleingänge und Testtakteingänge der einzelnen Schaltungskomponenten mit der Steuerung verbunden. Ausgehend von einem Initialisierungszustand, in dem die standardgemäße Schaltung inaktiv ist, wird anschließend eine festgelegte Abfolge von Operationen abgearbeitet.

Zunächst wird im allgemeinen der Befehlscode der einzelnen durchzuführenden Operationen in die jeweiligen Schaltungskomponenten geladen. Eine dem genannten Standard entsprechende Testlogik ist dabei derart ausgelegt, daß das Schieben der Befehlsworte auf Schaltungsteile, die durch diesen Befehl gesteuert werden, keinen Einfluß hat. Die an diese Schaltungsteile übertragenen Befehle werden dann geändert, wenn der Schiebevorgang geändert ist. Nachdem das Befehlswort geladen worden ist, wird die ausgewählte Testschaltung aktiviert. In einigen Fällen sind jedoch, bevor ein Abarbeiten erfolgen kann, Datenworte in die Testschaltung einzugeben. Das Laden der Datenworte erfolgt dabei prinzipiell in gleicher Weise wie zuvor das Laden der Befehlsworte, wobei die Datenworte keinen Einfluß auf die Befehlsworte haben. Die Umschaltung der Schnittstellen E1 bis E5 bzw. A1 bis A5 vom normalen Betriebsfall in den Testmodus erfolgt beim Ausführungsbeispiel mittels der Testmodussteuerung TMS abhängig von den Selektionssignalen sel. Die Bereitstellung und Auswertung der jeweiligen Bitmuster sowie die Erzeugung der Selektionssignale erfolgt durch eine nicht dargestellte externe Testeinrichtung.

Eine erfindungsgemäße Logikschaltung ist insbesondere dann vorteilhaft, wenn bereits vorhandene Schaltungsblöcke, für die es im einzelnen bereits fertige Prüfprogramme und Testmuster gibt, zusammen integriert werden. Die Anzahl der zusätzlichen Anschlußpins kann dabei sehr gering gehalten werden. Außerdem beschränkt sich der zusätzliche Aufwand auf bestehende Teststrukturen für die Schaltungsblöcke, einigen Anschlußpins zur Umschaltung der Betriebsweise, Multiplexern zur Aufschaltung der Schaltungsblöcke auf verschiedene Anschlußpins und gegebenfalls zusätzliche Boundary-Scan-Schnittstellen. Damit wird neben der Möglichkeit eines Bausteintests auch die Simmulation und Layout-Verifikation vor der Fertigung des Bausteins sowie eine erleichterte Schaltungsanalyse und eine Optimierung des Einsatzes im System beim Betrieb des Bausteins ermöglicht.

## Patentansprüche

1. Integrierte Logikschaltung mit mehreren miteinander gekoppelten, jeweils deaktivierbaren Schaltungsblöcken (SB1 bis SB5), die für sich jeweils durch Vergleich von an den Blockeingängen angelegten Eingangsbitmustern (ebm) mit daraus resultierenden Ausgangsbitmustern (abm) an den Blockausgängen testbar sind, und mit einer Testmodussteuerung (TMS), die zum Testen eines durch ein Selektionssignal (sel) ausgewählten, einzelnen Schaltungsblocks dessen Blockeingänge und Blockausgänge mittels einer Schalteinrichtung (SE) auf Anschlußpins, an die die Eingangsbitmuster (ebm) angelegt werden und die die Ausgangsbitmuster (abm) abgeben, aufschaltet und die übrigen Schaltungsblöcke deaktiviert.

2. Logikschaltung nach Anspruch 1,
**dadurch gekennzeichnet,** daß die Schaltungsblöcke (SB1 bis Sb5) durch die Testmodussteuerung (TMS) gesteuerte Schnittstellen (E1 bis E5, A1 bis A5) für einen Test nach dem Boundary-Scan-Verfahen aufweisen.
